Europäisches Patentamt

European Patent Office

Office européen des brevets

(11) Publication number: 0 375 134 A1

# EUROPEAN PATENT APPLICATION

(21) Application number: 89311547.7

(22) Date of filing: 08.11.89

(51) Int. Cl.5: C03C 10/02, C04B 35/00, H01L 39/12

(30) Priority: 21.12.88 US 287737

(43) Date of publication of application:
27.06.90 Bulletin 90/26

(84) Designated Contracting States:
DE FR GB

(71) Applicant: CORNING INCORPORATED
Houghton Park
Corning New York 14831(US)

(72) Inventor: Alexander, Michelle Grayson
1349 Elmira Road
Newfield New York(US)
Inventor: Quinn, Candace Jo
Thurber Road
Corning New York(US)
Inventor: Beall, George Halsey
106 Woodland Drive
Big Flats New York(US)
Inventor: Yu, Chyang John
2 Timber Lane
Painted Post New York(US)

(74) Representative: Smith, Sydney et al
Elkington and Fife Beacon House 113
Kingsway
London WC2B 6PP(GB)

(54) Bi-Ca-Sr-Cu-O superconducting glass ceramics.

(57) A glass ceramic superconductor is presented with a nominal stoichiometric composition of $Bi_{2-m}Pb_mCa_xSr_zN_nCu_wO_y$ family. The stoichiometric combination of $Ca_x$ and $Sr_z$ are such that x and z equal up to 10. Additional components, such as Pb, Ag, Li, K, Na, and Zn are added. Platelets are formed in a size range of up to 1000 Microns which are interwovenly, parallelly, and/or angularly juxtapositionally disposed to each other.

FIG.4

## Bi-Ca-Sr-Cu-O Superconducting Glass Ceramics

The present invention is directed towards a superconducting glass ceramic material and method for making the same. The composition of this glass ceramic material is derived from the Bi-Ca-Sr-Cu-O family of superconductors. In particular, it has been discovered that when the Ca to Sr combination is maintained in certain proportions that a material is produced comprising platelets or crystallites with an angularly juxtapositionally disposed orientation that exhibits very good superconductivity properties.

It is well known to those that are skilled in the superconductor art that this fast paced technology is in need of a composition and process whereby useful products can be manufactured. The ceramics of the first discovery, by Bednorz and Muller created excitement and happily spurred research, due to a significant raising of the critical temperature of superconductivity in their ceramic discovery.

The yttrium-barium-copper oxide (1:2:3) superconductor of the Chu et al discovery, while exhibiting superconductivity at higher temperatures, does not exhibit mechanical strength, useful crystal orientation, nor sufficient crystal positional proximity for useful products. The 1:2:3 superconductivity discovery cannot be trivialized, however, since this discovery has inspired others to invent additional ceramic superconductive compositions.

Recently, Maeda et al in the Japanese Journal of Applied Physics $27$, L209, (1988), disclosed the discovery of a new family of ceramic superconductors. This family is known as the Bi-Ca-Sr-Cu-O ceramic superconductors. The particular member of that family that excited interest is the $BiCaSrCu_2O_y$, known as 1:1:1:2. The 1:1:1:2 ceramic suffered similarly from the same poor properties exhibited by the initial 1:2:3 find.

The superconductor community is not standing on one foot. Since the Maeda et al revelations, others have come forward with discoveries of cousins to the 1:1:1:2 material. Komatsu et al in the Japanese Journal of Applied Physics, $27$, 4, April 1988 discloses a glass ceramic material with a composition from the Maeda family of superconductors. The glass ceramics introduced by Komatsu are 3:2:2:4 and 3:3:2:4 type Bi-Ca-Sr-Cu-O material. Komatsu first makes a glass with the material, rapidly quenches the glass, then anneals the glass forming a thin layer of ceramic material on the surface.

The invention herein disclosed is from the Bi-Ca-Sr-Cu-O family of superconductors. Additionally, the material is a glass ceramic. Following the nomenclature of the community, the compositions of the inventive glass ceramic are 2:1:2:2 and combinations therewithin. The material exhibits useful properties, such as greater mechanical strength, platelets or crystallites with highly defined geometries, and angular juxtapositional orientations conducive to conductivity.

### Summary of the Invention

A glass ceramic superconductor with nominal compositions of $Bi_2Ca_xSr_zCu_wO_y$ (such as $Bi_2CaSr_2Cu_2O_y$ known nominally as 2:1:2:2) and sibling compositions of $Bi_{2-m}Pb_mCa_xSr_zN_nCu_wO_y$ is presented wherein m is about 0-1, x is up to about 10, z is up to about 10, n is up to about 2, w ranges from about 2 to 7, and y is up to about 20. These compositions produce a superconducting glass ceramic wherein the mechanical properties of the material are enhanced, platelets or crystallites ranging in size up to 1000 microns are produced, the volume percent of superconductivity of the material is up to 60% at 65K, and the platelets or crystallites are interwovenly, angularly and/or parallelly, such as a mica-like structure, juxtapositionally disposed to each other producing a material conducive to conductivity. Crystal sizes up to 1000 microns have been observed indicating a potential use of these crystallites for a ribbon-like conductive medium. Additionally, since the material is at first a glass, it may be drawn out similarly to a fiber, formed into shapes as a glass, coated on a substrate, and subsequently crystallized to form the ceramic portion of the glass ceramic.

The process of producing the glass ceramic is equally inventive. The material is batched from carbonates and/or oxides of bismuth, strontium, calcium, and copper. The batched materials are melted at from $1000°$ to $1350°$ C and then rapidly quenched producing an amorphous structure. This intermediate material is a glass. The glass is subsequently heated about $650°$ to $910°$ C, preferably between about $800°$ to $890°$ C, in an oxygen rich environment or air forming platelets or crystallites intimately interspersed with the glass, forming a glass ceramic superconductor. An advantage provided by this glass ceramic material is the gain in control over the grain size of the ceramic phase. This control of very fine grains may provide high critical fields for magnetic shielding.

The 2:1:2:2 material is not without progeny of its own. Various substitutions of any of the stoichiometric components in 2:1:2:2 can be made with silver, tin, lead, zinc, sodium, potassium, lithium, and anions such as fluoride, as herein disclosed.

The critical temperature onset of superconductivity of the material is up to about 110K with the temperature of zero resistance about 70K. The volume percent of superconductivity ranges up to 60% at 65K.

Brief Description of the Drawings

FIG. 1 is an SEM micrograph showing the angularly juxtaposed platelets.

FIG. 2 is an SEM micrograph showing parallelly juxtaposed platelets.

FIG. 3 is an SEM micrograph showing the dimensions and extent of the interwoven characteristic of the platelets.

FIG. 4 is a plot of resistance vs. Temperature.

FIG. 5 is a plot of the magnetization vs. applied magnetic field.

Detailed Description of the Preferred Embodiments

In Example I, the preferred embodiment, 310.6 grams of $Bi_2O_3$, 56.1 grams of CaO, 147.6 grams of $SrCO_3$, and 106.1 grams of CuO were mixed together using a tumbler, for 60 minutes. The batch was placed in a 500 cc platinum crucible, then heated in a furnace in air at approximately $1150°$ C. The furnace was maintained at this temperature for 50 minutes. The melt was retrieved from the furnace and poured onto a stainless steel table. The melt was then pressed with a stainless steel block to rapidly quench the liquid. The resulting solid was black and exhibited glassy fracture.

Several samples from the glass were placed in a tube furnace equipped for oxygen flow. The samples were placed in the furnace such that the highest amount of surface area was exposed to the furnace environment. The samples were secured inside zirconia rings. The rings were placed on porous zirconia setter plates. The tube was sealed and oxygen gas flowed through the tube during heat-up, maintenance, and cool down of the furnace. The furnace was brought up to the maintenance temperature of about $890°$ C from room temperature in approximately 8 hours. This temperature was maintained for about 12 hours. The sample ladened furnace was allowed to cool to room temperature for about 15 hours.

The heat treatment provided samples containing many small crystals. Optical microscopy revealed some samples exhibiting large platelets, which reflected light. The samples appeared to have thermally deformed, indicating that the melting temperature of the material may have been broached. An examination of the bottom of the samples, bottom defined as the area of the sample closest to the zirconia setter plates, revealed a different morphology than the top of the samples. The bottom part of the samples appeared to exhibit more porosity.

Samples containing large platelets contained 40 to 55 percent superconductor by volume, as determined from magnetization vs. applied field measurements. Magnetization vs. applied magnetic field measurements were made with a vibrating sample magnetometer, using fields up to 10,000 Gauss. Cooling was provided by a flow cryostat. Data could be taken down to 65K by pumping on the liquid nitrogen coolant. Samples consisted of ground powders stuffed into small nylon sample holders. The field was applied perpendicular to the long axis of the sample holders.

The resistivity measurements were made by the four probe method. Four gold strips were evaporated onto the solid glass ceramic samples and electrical contacts were made to these with silver epoxy. A flow cryostat, using liquid helium coolant, was used to lower the temperature of samples to about 10K.

The resistivity of the samples was approximately $10^{-4}$ ohm cm at room temperature, exhibiting metallic behavior. This characteristic decreased with decreasing temperature. As the 120K temperature was approached a dip of about 13% in resistance vs. temperature was noted. This dip indicated the presence of the very high $T_c$ phase of Bi-Ca- Sr-Cu-O. The resistance began to decrease rapidly at about 85K, reaching zero at 70K.

Scanning electron microscopy revealed the presence of about $100\mu$ to $200\mu$ in size platelets. Powder x-ray diffraction patterns show the presence of a single crystalline phase, with structure matching the structure of $Bi_2(CaSr)_3Cu_2O_8$. X-ray diffraction also revealed a glass phase to the material.

In Example II, the glass of Example I was placed in the same furnace as Example I, but the samples

3

were laid flat (horizontally oriented) on porous zirconia setter plates. The furnace and heat treatment method were similar to that used in Example I. This heat treatment resulted in materials with some porosity, that were not warped. SEM revealed these samples to have angularly and parallelly juxtapositionally opposed grains of 10 to 20 $\mu$ size. Powder x-ray diffraction showed the presence of a single crystalline phase matching the structure of $Bi_2(CaSr)_3Cu_2O_8$ and a glass phase. Magnetization vs. applied field measurements indicated 20 to 55 percent superconductor, by volume, at about 67 K. The room temperature resistivity of this sample was approximately $10^{-3}$ ohm cm, 10 times higher than that of the material in Example 1. Resistivity measurements indicated poorer electrical connection between grains than seen in the materials of Example I.

In Example III, the glass of Example I was placed in the same furnace as Example I and oriented as in Example II. The heat treatment method was similar to Example II, except that the temperature of 890°C was maintained for only 3 hours. This glass ceramic was denser than the material in Example II and exhibited about 10 volume percent superconductor at about 67 K, by magnetization measurements. Powder x-ray diffraction showed the presence of a crystalline phase matching the structure of $Bi_2(CaSr)_3Cu_2O_8$, additional lines related to the low temperature crystalline phase of this system, and glass.

In Example IV, the glass of Example I was oriented as in Example II, then two porous zirconia bricks were placed on top of it. This was done in an attempt to further align grains in an orientation conducive to conductivity. The heat treatment method was similar to that of Example I. The resulting glass ceramic resembled that of Example III and exhibited about 4 volume percent superconductivity at about 67 K. Powder x-ray diffraction showed the presence of a crystalline phase matching the structure of $Bi_2(CaSr)_3Cu_2O_8$, additional unidentified lines, and glass.

In Example V, a batch of the same composition as Example I was mixed as in Example I. This batch was placed into a 500 cc alumina crucible, then melted and quenched as in Example I. The resulting glass was heat treated in the same furnace as Example I, with an orientation similar to Example II. The heat treatment method of Example I was followed. The resulting material was somewhat porous and slightly warped. Magnetization measurements indicated 6 volume percent superconductor at about 65 K. Powder x-ray diffraction showed the presence of a crystalline phase matching the structure of $Bi_2(CaSr)_3Cu_2O_8$, additional unidentified lines, and a glass phase.

In Example VI, a batch of the same composition as Example I was mixed as in Example I. The batch was placed in a 500 cc alumina crucible, then heated in air at approximately 1150°C for about 1 hour, with oxygen gas flowing over the top of the melt for about 15 minutes. The melt was then quenched as in Example I. The resulting glass was heat treated in the same furnace as Example I, with the same orientation as Example II. The heat treatment method of Example I was followed. The resulting glass ceramic was porous and warped, having about 10 volume percent superconductor at about 67 K. Powder x-ray diffraction showed the presence of a crystalline phase matching the structure of $Bi_2(CaSr)_3Cu_2O_8$, additional unidentified lines, and a glass phase.

In Example VII, 310.6 g of $Bi_2O_3$, 100.1 g of $CaCO_3$, 147.6 g of $SrCO_3$, and 106.1 g of CuO were mixed, melted and quenched as Example III. The resulting glass was heat treated similarly to that in Example I, with a similar orientation to that of Example II. The heat treatment method of Example I was followed. The resulting glass ceramic was porous and warped. SEM revealed this material to have angularly and parallelly juxtapositionally opposed grains of 20 to 100 $\mu$ size and needle-shaped particles of about 100 $\mu$ in size, which have been identified as primarily calcium copper oxides. Powder x-ray diffraction showed the presence of a crystalline phase matching the structure of $Bi_2(CaSr)_3Cu_2O_8$, additional unidentified lines, and a glass phase. Magnetization vs. applied field measurements indicated 10 to 50 percent superconductor, by volume, at about 67 K.

In Example VIII, the glass of Example VII was heat treated similarly to that as in Example I, with the same orientation as Example II. The heat treatment method was similar to Example I, except that the temperature of 890°C was maintained for a period of 48 hours. The resulting glass ceramic resembled that of Example V. SEM revealed a morphology similar to that of Example VII. Powder x-ray diffraction showed the presence of a crystalline phase matching the structure of $Bi_2(CaSr)_3Cu_2O_8$, additional unidentified lines, and glass. Magnetization vs. applied field measurements indicated 10 to 50 percent superconductor, by volume, at about 67 K.

In Example IX, the glass of Example VII was heat treated similarly to that as in Example I, with an orientation similar to Example II. The furnace was brought up to the maintenance temperature of 825°C in about 8 hours, then this temperature was maintained for 24 hours. The furnace was allowed to cool to room temperature over approximately 15 hours. The resulting material was a fine grain glass ceramic, with about 3 volume percent superconductor at about 67 K. This material had metallic resistance behavior above a $T_c$ of 85 K, with no dip in resistance vs. temperature at about 110 K. The room temperature resistivity of this

4

material was approximately $10^{-3}$ ohm cm, 10 times higher than that of the material in Example I. Powder x-ray diffraction showed the presence of a crystalline phase matching the structure of $Bi_2(CaSr)_3Cu_2O_8$ and glass.

In Example X, the glass of Example VII was ground and pressed into small wafers. These wafers were placed on porous zirconia setter plates and placed in the same furnace used for Example I. The heat treatment schedule was similar to that in Example I. The resulting glass ceramic wafers exhibited about 5 volume percent superconductor. Powder x-ray diffraction showed the presence of a crystalline phase matching the structure of $Bi_2(CaSr)_3Cu_2O_8$ and glass.

In Example XI, the glass of Example 7 was ground and pressed into small wafers. These wafers were placed on porous zirconia setter plates and placed in the same furnace used for Example I. The heat treatment schedule was similar to that of Example I, except that the maximum temperature reached was about 880° C. This temperature was held for 12 hours. The resulting glass ceramic wafers exhibited about 15 volume percent superconductor at about 65 K. Powder x-ray diffraction showed the presence of a crystalline phase matching the structure of $Bi_2(CaSr)_3Cu_2O_8$ and glass.

In Example XII, 349.5 g of $Bi_2O_3$, 75.1 g of $CaCO_3$, 221.43 g of $SrCO_3$, and 119.3 g of CuO were mixed as in Example I. The batch was placed in a 500 cc platinum crucible, then melted and quenched as in Example I. The resulting glass was heat treated in the same furnace used for Example I, with a similar orientation as that of Example II. The heat treatment method was similar to Example I. This heat treatment resulted in porous materials that were not warped. This material exhibited about 10 volume percent superconductor at about 65 K.

In Example XIII, a batch of the same composition as Example XII was mixed according to the method of Example I. The batch was placed in a 500 cc alumina crucible, then melted and quenched similarly to Example I. The resulting glass was heat treated in the same furnace as Example I, with a similar orientation as in Example II. The heat treatment method was similar to Example I. The heat treatment resulted in porous materials that were not warped. This material exhibited about 5 volume percent superconductor at about 65 K. Powder x-ray diffraction showed the presence of a crystalline phase matching the structure of $Bi_2(CaSr)_3Cu_2O_8$ and glass.

In Example XIV, the glass of Example XIII was placed in a box-type furnace, with a similar orientation as that of Example II. The furnace was brought up to 700° C in 7 hours, held at that temperature for 12 hours, raised to 865° C in about 2 hours, held at 865° C for 12 hours, raised to 885° C in about two hours, held at 885° C for 12 hours, then cooled to room temperature in about 7 hours. The furnace atmosphere was oxygen. The resulting glass ceramic was porous and exhibited about 5 volume percent superconductor at about 65 K. Powder x-ray diffraction showed the presence of a crystalline phase matching the structure of $Bi_2(CaSr)_3Cu_2O_8$ and a glass phase.

In Example XV, the glass of Example XIII was heat treated with the same schedule as Example XIV, in an orientation similar to that of Example II, in a box-type furnace. The furnace atmosphere was air. The resulting glass ceramic exhibited only 1 volume percent superconductor at about 65 K. Powder x-ray diffraction showed the presence of a crystalline phase matching the structure of $Bi_2(CaSr)_3Cu_2O_8$ and a glass phase.

In Example XVI, a batch of the same composition as Example XIII was mixed as in Example I. The batch was placed in a 500 cc alumina crucible, then heated in air at approximately 1150° C for about 1 hour, with oxygen gas flowing over the top of the melt for about 15 minutes. The melt was quenched similar to the method in Example I. The resulting glass was heat treated in a box-type furnace, with an orientation similar to that of Example II. The furnace was brought up to the maintenance temperature of 820° C over about 5 hours, kept at that temperature for 12 hours, and slowly cooled to room temperature. The furnace atmosphere was air. This treatment resulted in a fine grain glass ceramic, having about 1 volume percent superconductor at about 65 K. Powder x-ray diffraction showed the presence of a crystalline phase matching the structure of $Bi_2(CaSr)_3Cu_2O_8$ and a glass phase.

In Example XVII, the glass of Example XVI was heat treated in the furnace used to heat Example I, with an orientation similar to that of Example II. The furnace was brought up to the maintenance temperature of 710° C in about 7 hours, then held at this temperature for 24 hours. The furnace was allowed to cool back to room temperature over about 15 hours. Oxygen gas was flowed through the furnace during heat up, temperature maintenance, and cool down. The result was an extremely fine grained glass ceramic. TEM photographs show crystalline grains of 0.1 to 1 $\mu$ size. These materials exhibited only 1 volume % superconductor at about 65 K, but the first critical fields, $H_{c1}$, measured were extremely large (700 to 900 Gauss), due to the fine grain size. Powder x-ray diffraction showed the presence of two crystalline phases, one matching the structure of $Bi_2(CaSr)_3Cu_2O_8$ and one related to the low temperature crystalline phase of this system, and a glass phase.

In Example XVIII, the glass of Example XVI was treated in the furnace of Example XVI, in the orientation of Example II. The furnace was brought up to 690°C over about 4 hours, maintained at that temperature for about 62 hours, then slowly cooled to room temperature. The resulting material was similar in appearance and morphology to that of Example XVII. These materials exhibited 1 volume percent superconductor at about 65 K and had enormous first critical fields of 1000 to 2000 Gauss. Powder x-ray diffraction showed the presence of two crystalline phases, one matching the structure of $Bi_2(CaSr)_3Cu_2O_8$ and one related to the low temperature crystalline phase of this system, and a glass phase.

In Example XIX, the glass of Example XVI was treated in the furnace similar to the method of Example XVI, with an orientation similar to that of Example II. The furnace was brought up to 560°C over about 4 hours, maintained at that temperature for 3 hours, and slowly cooled to room temperature. The resulting material was still glassy in appearance and exhibited no superconductivity. Powder x-ray diffraction showed the presence of a crystalline phase different from the structure of $Bi_2(CaSr)_3Cu_2O_8$ and a glass phase.

In Example XX, the glass of Example XVI was treated in the furnace according to the method of Example I, with the orientation of Example II. The furnace was brought up to 440°C over about 4 hours, maintained at this temperature for 3 hours, then slowly cooled to room temperature. Oxygen gas was flowed through the furnace during heat up, maintenance, and cool down. The resulting material was predominantly glass, though a small amount of crystalline material could be seen. This material exhibited no superconductivity. Powder x-ray diffraction showed the presence of a crystalline phase different from the structure of $Bi_2(CaSr)_3Cu_2O_8$, however, the glass phase was still observed.

In Example XXI, the glass of Example XVI was placed into the furnace used for Example XIV, which was already at 820°C. The sample was left in the furnace for 30 minutes, then removed to room temperature. The entire heat treatment took place in air. The resulting material was partly glass and partly glass ceramic, with striations of crystalline material interspersed with glass. This material exhibited less than 1 volume percent superconductor, but had a fairly large first critical field of 200 Gauss, due to tiny crystalline grains. Powder x-ray diffraction showed the presence of a crystalline phase matching the structure of $Bi_2(CaSr)_3Cu_2O_8$ and a glass phase.

In Example XXII, a batch similar to that of Example VII was mixed and melted according to the method in Example VII. The melt was retrieved from the furnace and poured onto a room temperature stainless steel table. This time, the melt was not pressed with a stainless steel block. The resulting material was mostly crystalline, with a thin layer of glass at the surface that had been in contact with the table and, thus, was the most rapidly quenched. Powder x-ray diffraction showed a crystalline phase unrelated to the structure of $Bi_2(CaSr)_3Cu_2O_8$ and glass. This material was heat treated in the furnace used to heat treat Example I, in the orientation similar to that of Example II. The heat treatment method was similar to that of Example IX. The resulting material was a glass ceramic. Powder x-ray diffraction showed the presence of two crystalline phases, one matching the structure of $Bi_2(CaSr)_3Cu_2O_8$, and glass.

In Example XXIII, 327.7 g of $Bi_2O_3$, 66.5 g of CaO, 161.4 g of $SrCO_3$, and 143.7 g of CuO were mixed, melted, and quenched according to the method in Example I. The resulting glass was given a heat treatment in the furnace used for heating Example I, but in an orientation similar to that of Example II. The heat treatment method was similar to that used in Example I. The resulting glass ceramic was somewhat porous. Magnetization measurements indicated 2 to 15 volume percent superconductor at ~67 K.

In Example XXIV, 310.6 g of $Bi_2O_3$, 56.1 g of CaO, 98.4 g of $SrCO_3$, and 106.1 g of CuO were mixed, melted and quenched according to the method in Example I. This glass was heat treated in the same furnace used for Example I, with a similar orientation as Example I, and similar heat treatment as in the method of Example IX. The resulting glass ceramic was dense. Tiny shiny crystalline flakes could be seen under an optical microscope. This material exhibited 3 volume percent superconductor at about 67 K, by magnetization measurements.

In Example XXV, the glass of Example XXIV was treated similarly to Example XXIV, but the glass pieces were oriented in the same manner as in Example II. The resulting material was a fine grain glass ceramic.

In Example XXVI, 310.6 g of $Bi_2O_3$, 100.1 g of $CaCO_3$, 98.4 g of $SrCO_3$, and 106.1 g of CuO were mixed, melted, and quenched according to the method of Example I. This glass was heat treated in the same furnace used to heat Example I, with the treatment similar to Example IX. Pieces were oriented in much the same manner as in Example I. The resulting glass ceramic had an appearance similar to that of Example XXIV, but also contained shiny spheroids of about 1 to 2 mm diameter. Magnetization measurements indicated 4 volume percent superconductor at about 67 K.

In Example XXVII, the glass of Example XXVI was heat treated as in a manner similar to Example XXVI, but the samples were oriented like those in Example II. The resulting material was a fine grain glass ceramic.

6

In Example XXVIII, 349.5 g of $Bi_2O_3$, 75.1 g of $CaCO_3$, 221.4 g of $SrCO_3$, and 125.3 g of CuO were mixed, melted, and quenched according to the method of Example I. The resulting glass was heat treated in the same furnace used to heat Example I, with the heat treatment method similar to that of Example I, except that the furnace was maintained at a temperature of 880°C for 12 hours. The sample was oriented in a manner similar to Example I. Incongruent melting had taken place, leaving the samples somewhat porous and deformed. Many small shiny crystallites could be observed under the optical microscope. Magnetization measurements indicated 10 volume percent superconductor at about 67 K.

In Example XXIX, the glass of Example XXVIII was heat treated according to the method used in Example XVIII, but the sample was oriented similarly to that in Example II. Incongruent melting had apparently taken place, leaving the samples somewhat porous and deformed. Many small shiny crystallites could be observed under the optical microscope. Magnetization measurements indicated 3 volume percent superconductor at about 67 K.

In Example XXX, 349.5 g of $Bi_2O_3$, 75.2 g of $CaCO_3$, 221.4 g of $SrCO_3$, 122.3 g of CuO, and 4.3 g of $Ag2O$ were mixed, melted, and quenched according to the method in Example I. The resulting glass was heat treated in the same furnace and with the method used for Example I, but the furnace was maintained at 880°C for 12 hours. The sample was oriented in a manner similar to Example I. The resulting fine grain glass ceramic exhibited 15 volume percent superconductor at about 67 K, from magnetization measurements.

In Example XXXI, the glass of Example XXX was heat treated in a manner similar to Example XXX, but the sample was oriented similarly to Example II. The resulting fine grain glass ceramic exhibited 9 volume percent superconductor at about 67 K, from magnetization measurements.

In Example XXXII, 349.5 grams of $Bi_2O_3$, 75.1 grams of $CaCO_3$, 221.4 grams of $SRCO_3$, and 125.3 grams of CuO were mixed, and quenched as in Example V. The resulting glass was heat treated in the furnace of Example I, with the orientation similar to Example II. The furnace was brought up to the maintenance temperature of 700°C in about 7 hours, then held at this temperature for 24 hours. The furnace was allowed to cool back to room temperature over about 15 hours. Oxygen gas was flowed through the furnace during heat up, temperature maintenance, and cool down. The result was a fine grain glass ceramic. Powder x-ray analysis showed a crystalline phase similar to the structure of $Bi_2(CaSr)_3Cu_2O_8$. The material had less than one volume percent superconductor, by magnetization measurements, and had a first critical field of 400 Gauss.

In Example XXXIII, 349.5 grams of $Bi_2O_3$, 75.1 grams of $CaCO_3$, 221.4 grams of $SrCO_3$, and 125.3 grams of CuO were mixed, melted, and quenched as in Example V. The resulting glass was heat treated in the furnace of Example I, with the orientation of Example II. The heat treatment method was similar to that of Example XXXII. The result was a fine grain glass ceramic. Powder x-ray showed a crystalline phase similar to the structure of $Bi_2(CaSr)_3Cu_2O_8$. The material had less than one volume percent superconductor, by magnetization, and had a first critical field of 300 Gauss.

In Example XXXIV, two samples of glass ceramic of Example VII was given an additional oxygen atmosphere heat treatment at 890°C. The heat treatment procedure was similar to that in Example VII, except that the maximum temperature was maintained for 24 hours. Magnetization vs. applied field measurements indicated that these samples had 40 to 60 volume percent superconductor at 67 K, as they had before the second heat treatment.

Table I presents the as analyzed stoichiometric concentrations of the various Bi-Ca-Sr-Cu-O compositions and their associated Examples.

TABLE I

| Composition | Example Number |
|---|---|
| $Bi_2Ca_{1.56}Sr_{1.47}CU_{2.07}O_{8.44}$ | 1A |
| $Bi_2Ca_{1.33}Sr_{1.41}Cu_{1.82}O_{7.79}$ | 1 |
| $Bi_2Ca_{1.69}Sr_{1.55}Cu_{2.57}O_{9.3}$ | 2 |
| $Bi_2Ca_{1.51}Sr_{1.65}Cu_{2.70}O_{9.97}$ ($Al_{0.21}$) | 7 |
| $Bi_2Ca_{5.76}Sr_{8.32}Cu_{9.29}O_{30.86}$ ($Al_{1.75}$) | 12 |
| $Bi_2Ca_{1.95}Sr_{1.65}Cu_{2.69}O_{10.1}$ ($Al_{0.21}$) | 34A |
| $Bi_2Ca_{2.41}Sr_{1.76}Cu_{3.17}O_{11.2}$ ($Al_{0.30}$) | 34 |

The concentrations of all samples were normalized to the $Bi_2$ component. The concentration of Example 12 is outside the range. It is speculated that Bi may have been lost during processing of this Example. Aluminum is in parenthesis since it is speculated that firstly, aluminum is probably derived from the alumina crucible used for heating the sample, and secondly the aluminum is speculated to site in the glass phase.

Table II presents the batch starting materials for Examples XXXV through XLVIII.

TABLE II.

| STARTING BATCH MATERIALS AND THEIR WEIGHT | | | | | |
|---|---|---|---|---|---|
| Starting Materials | | | | | |
| Examples | $Bi_2O_3$(gm) | $CaCO_3$(gm) | | $SrCO_3$(gm) | CuO(gm) |
| XXXV | 163.1 | 140.1 | | 206.7 | 167.0 |
| XXXVI | 163.1 | 70.0 | | 103.3 | 83.5 |
| XXXVII | 244.6 | 70.0 | | 103.3 | 83.5 |
| XXXVIII | 244.6 | 70.0 | | 103.3 | 111.4 |
| XXXIX | 163.1 | 35.0 | | 103.3 | 55.7 |
| XL | 163.1 | 105.1 | | 206.7 | 139.2 |
| Examples | $Bi_2O_3$ (gm) | PbO (gm) | $Ag_2O$ (gm) | $CaCO_3$ (gm) | $SrCO_3$ (gm) | CuO (gm) |
| XLI | 138.6 | 19.5 | 2.0 | 140.1 | 206.7 | 167.0 |
| XLII | 138.6 | 11.7 | 6.1 | 140.1 | 206.7 | 167.0 |
| XLIII | 122.3 | 35.2 | 2.0 | 140.1 | 206.7 | 167.0 |
| XLIV | 138.6 | 23.4 | 16.2 | 140.1 | 186.0 | 167.0 |
| XLV | 138.6 | 23.4 | 40.6 | 140.1 | 155.0 | 167.0 |
| Examples | $Bi_2O_3$ (gm) | PbO (gm) | $Li_2CO_3$ (gm) | $CaCO_3$ (gm) | $SrCO_3$ (gm) | CuO (gm) |
| XLVI | 138.6 | 23.4 | 5.2 | 140.1 | 186.0 | 167.0 |
| Examples | $Bi_2O_3$ (gm) | PbO (gm) | $Na_2CO_3$ (gm) | $CaCO_3$ (gm) | $SrCO_3$ (gm) | CuO (gm) |
| XLVII | 138.6 | 23.4 | 3.7 | 140.1 | 196.3 | 167.0 |
| Examples | $Bi_2O_3$ (gm) | PbO (gm) | $K_2CO_3$ (gm) | $CaCO_3$ (gm) | $SrCO_3$ (gm) | CuO (gm) |
| XLVIII | 138.6 | 23.4 | 9.7 | 140.1 | 186.0 | 167.0 |

Table III presents the stoichiometric ratios of the compositions of Examples XXXV through XLVIII. Additionally, the compositions have been normalized to $Bi_2$ or $(Bi,Pb)_2$ depending upon the composition to facilitate comparison between the various Examples with regard to composition.

## TABLE III. NORMALIZED COMPOSITIONS TO (Bi+Pb) or Bi=2

(a) Bi-Ca-Sr-Cu-O System:

| Example | Composition | Normalized Composition |
|---------|-------------|------------------------|
| XXXV | $Bi_2Ca_4Sr_4Cu_6O_x$ | $Bi_2Ca_4Sr_4Cu_6O_x$ |
| XXXVI | $Bi_2Ca_2Sr_2Cu_3O_x$ | $Bi_2Ca_2Sr_2Cu_3O_x$ |
| XXXVII | $Bi_3Ca_2Sr_2Cu_3O_x$ | $Bi_2Ca_{1.33}Sr_{1.33}Cu_2O_x$ |
| XXXVIII | $Bi_3Ca_2Sr_2Cu_4O_x$ | $Bi_2Ca_{1.33}Sr_{1.33}Cu_{2.67}O_x$ |
| XXXIX | $Bi_2CaSr_2Cu_2O_x$ | $Bi_2CaSr_2Cu_2O_x$ |
| XL | $Bi_2Ca_3Sr_4Cu_5O_x$ | $Bi_2Ca_3Sr_4Cu_5O_x$ |

(b) Bi-Pb-Ca-Sr-Ag-O System:

| Example | Composition | Normalized Composition |
|---------|-------------|------------------------|
| XLI | $Bi_{1.7}Pb_{0.25}Ca_4Sr_4Ag_{0.05}Cu_6O_x$ | $(Bi_{1.74}Pb_{0.26})(Ca_{4.1}Sr_{4.1}Ag_{0.051})Cu_{6.15}O_x$ |
| XLII | $Bi_{1.7}Pb_{0.15}Ca_4Sr_4Ag_{0.15}Cu_6O_x$ | $(Bi_{1.84}Pb_{0.16})(Ca_{4.32}Sr_{4.32}Ag_{0.054})Cu_{6.49}O_x$ |
| XLIII | $Bi_{1.5}Pb_{0.45}Ca_4Sr_4Ag_{0.05}Cu_6O_x$ | $(Bi_{1.54}Pb_{0.46})(Ca_{4.1}Sr_{4.1}Ag_{0.051})Cu_{6.15}O_x$ |
| XLIV | $Bi_{1.7}Pb_{0.3}Ca_4Sr_{3.6}Ag_{0.4}Cu_6O_x$ | $(Bi_{1.7}Pb_{0.3})(Ca_4Sr_{3.6}Ag_{0.4})Cu_6O_x$ |
| XLV | $Bi_{1.7}Pb_{0.3}Ca_4Sr_3AgCu_6O_x$ | $(Bi_{1.7}Pb_{0.3})(Ca_4Sr_3Ag)Cu_6O_x$ |

(c)  Bi-Pb-Ca-Sr-Li-O System:

XLVI    $Bi_{1.7}Pb_{0.3}Ca_4$        $(Bi_{1.7}Pb_{0.3})$
        $Sr_{3.6}Li_{0.4}Cu_6O_x$    $(Ca_4Sr_{3.6}Li_{0.4})Cu_6O_x$

(d)  Bi-Pb-Ca-Sr-Na-Cu-O System:

XLVII   $Bi_{1.7}Pb_{0.3}Ca_4$        $(Bi_{1.84}Pb_{0.3})$
        $Sr_{3.8}Na_{0.2}Cu_6O_x$    $(Ca_4Sr_{3.8}Na_{0.2})Cu_6O_x$

(e)  Bi-Pb-Ca-Sr-K-Cu-O System:

XLVIII  $Bi_{1.7}Pb_{0.3}Ca_4$        $(Bi_{1.7}Pb_{0.3})$
        $Sr_{3.6}K_{0.4}Cu_6O_x$     $(Ca_4Sr_{3.6}K_{0.4})Cu_6O_x$

Table IV presents experimental parameters which distinguish Examples XXXV through XLVIII and the resulting percent superconductivity observed for each Example.

TABLE IV.  GLASS MELT, CERAM CONDITIONS AND THE
PERCENTAGE OF SUPERCONDUCTING PHASE

(a)  Bi-Ca-Sr-Cu-O System:

| Example | Composition | Glass Melt Temp(°C) | Annealing Cond (°C) | % Supercond at 67°K |
|---------|-------------|---------------------|---------------------|---------------------|
| XXXV | $Bi_2Ca_4Sr_4Cu_6O_x$ | 1300 | 885/Oxy/22hr | 1.5% |
| XXXVI | $Bi_2Ca_2Sr_2Cu_3O_x$ | 1150 | 885/Oxy/22hr | 27% |
| XXXVII | $Bi_3Ca_2Sr_2Cu_3O_x$ | 1150 | 865/Air/66hr | 13% |
|  |  | 1150 | 880/Air/27hr | 13-15% |
|  |  | 1150 | 885/Oxy/22hr | 11-12% |
| XXXVIII | $Bi_3Ca_2Sr_2Cu_4O_x$ | 1150 | 885/Oxy/22hr | 7% |
| XXXIX | $Bi_2CaSr_2Cu_2O_x$ | 1150 | 885/Oxy/22hr | 12% |
| XL | $Bi_2Ca_3Sr_4Cu_5O_x$ | 1150 | 885/Oxy/22hr | 1% |

(b) <u>Bi-Pb-Ca-Sr-Ag-O System</u>:

| | | | | | |
|---|---|---|---|---|---|
| XLI | $Bi_{1.7}Pb_{0.25}Ca_4$ $Sr_4Ag_{0.05}Cu_6O_x$ | 1250 | 845/Air/34hr | 6% |
| XLII | $Bi_{1.7}Pb_{0.15}Ca_4$ $Sr_4Ag_{0.15}Cu_6O_x$ | 1250 | 845/Air/34hr | 3% |
| XLIII | $Bi_{1.5}Pb_{0.45}Ca_4$ $Sr_4Ag_{0.05}Cu_6O_x$ | 1250 | 845/Air/34hr | 6% |
| XLIV | $Bi_{1.7}Pb_{0.3}Ca_4$ $Sr_{3.6}Ag_{0.4}Cu_6O_x$ | 1250 | 845/Air/34hr | 18% |
| | | 1250 | 865/Air/66hr | 18% |
| XLV | $Bi_{1.7}Pb_{0.3}Ca_4$ $Sr_3AgCu_6O_x$ | 1250 | 845/Air/34hr | 6% |

(c) <u>Bi-Pb-Ca-Sr-Li-O System</u>:

| | | | | |
|---|---|---|---|---|
| XLVI | $Bi_{1.7}Pb_{0.3}Ca_4$ $Sr_{3.6}Li_{0.4}Cu_6O_x$ | 1250 | 845/Air/34hr | 5% |

(d) <u>Bi-Pb-Ca-Sr-Na-Cu-O System</u>:

| | | | | |
|---|---|---|---|---|
| XLVII | $Bi_{1.7}Pb_{0.3}Ca_4$ $Sr_{3.8}Na_{0.2}Cu_6O_x$ | 1300 | 845/Air/69hr | 1.3% |

(e) <u>Bi-Pb-Ca-Sr-K-Cu-O System</u>:

| | | | | |
|---|---|---|---|---|
| XLVIII | $Bi_{1.7}Pb_{0.3}Ca_4$ $Sr_{3.6}K_{0.4}Cu_6O_x$ | 1300 | 845/Air/69hr | 1.3% |

Table V presents annealing parameters and physical observations of Examples XXXV through XLVIII after the samples had been cerammed. Onset @ a specific temperature means the onset of superconductivity as known to those skilled in the art.

## TABLE V.   OBSERVATIONS OF SAMPLES AFTER CERAM

(a)  <u>Bi-Ca-Sr-Cu-O System</u>:

| Example | Annealing Condition (°C) | Wt Change After Annealing | Comments |
|---|---|---|---|
| XXXV | 885/Oxy/22hr | -3.7% | slightly warped |
| XXXVI | 885/Oxy/22hr | +0.26% | flat, onset @ 86°K |
| XXXVII | 865/Air/66hr | | rippled |
| | 880/Air/27hr | -7.3% | rippled |
| | 885/Oxy/22hr | | partially melt, warped, porous |
| XXXVIII | 885/Oxy/22hr | | partially melt, stuck to setter |
| XXXIX | 885/Oxy/22hr | | partially melt, stuck to setter |
| XL | 885/Oxy/22hr | 0.73% | slightly warped |

(b)  <u>Bi-Pb-Ca-Sr-Ag-O System</u>:

| Example | Annealing Condition (°C) | Wt Change After Annealing | Comments |
|---|---|---|---|
| XLI | 845/Air/34hr | | slightly warped |
| XLII | 845/Air/34hr | | slightly warped |
| XLIII | 845/Air/34hr | | warped |
| XLIV | 845/Air/34hr | | warped, onset @ 90°K |
| | 865/Air/66hr | | partially melt, stuck to setter |
| XLV | 845/Air/34hr | | severely warped |

(c)  <u>Bi-Pb-Ca-Sr-Li-O System</u>:

| Example | Annealing Condition (°C) | Wt Change After Annealing | Comments |
|---|---|---|---|
| XLVI | 845/Air/34hr | | warped |

(d)  <u>Bi-Pb-Ca-Sr-Na-Cu-O System</u>:

| Example | Annealing Condition (°C) | Wt Change After Annealing | Comments |
|---|---|---|---|
| XLVII | 845/Air/69hr | | warped |

(e)  Bi-Pb-Ca-Sr-K-Cu-O System:

XLVIII    845/Air/69hr                    slightly warped

$Sr_{3.6}K_{0.4}Cu_6O_x$                    ----

In Example XLIX, 544 grams of $Bi_2O_3$, 69 grams of CaO, 50 grams of ZnO, 258 grams of $SrCO_3$, 185 grams of CuO, and 15 grams of $Al_2O_3$ were mixed and heated as in Example I. The molten liquid was poured onto a stainless steel table and contained within a stainless steel mold. The resulting glass piece was about 0.5 inch (1.72 cm) thick. The glass was heat treated in the furnace and with the same method used for Example I. The furnace was maintained at 850°C for 12 hours. The sample was oriented in a manner similar to Example I. After heat treatment, the sample had a flat, fine grained appearance. The inside was comprised of shiny crystallites, up to 1000 microns in size. Powder x-ray analysis showed a crystalline phase with a structure similar to that of $Bi_2(CaSr)_3Cu_2O_8$, unidentified lines, and glass. SEM indicated that the crystallites were comprised of flat, mica-like grains of up to several hundred microns in length and up to 1 micron thick. Magnetization measurements indicate 4 volume percent superconductor at 67K.

In Example L, 530 grams of $Bi_2O_3$, 67 grams of CaO, 333 grams of $SrCO_3$, and 180 grams of CuO were mixed as in Example I. The batch was placed in a 500 cc alumina crucible and melted at 1150°C. The batch was then heat treated similar to Example 22 and showed x-ray data similar to that of Example 22. Magnetization measurements indicated 12 volume percent superconductor at 67K.

In Example LI, 563 grams of $Bi_2O_3$, 78 grams of CaO, 276 grams of $SrCO_3$, and 178 grams of CuO were mixed, melted, and quenched as in Example L. The resulting material was partly glass and partly crystalline, as in Example L. This material was heat treated in a manner similar to Example L. The resulting material was a glass ceramic, composed of a $Bi_2(CaSr)_3Cu_2O_8$ type phase, another crystalline phase, and glass. Magnetization measurements indicated 5 volume percent superconductor at 67K.

In Example LII, 530 grams of $Bi_2O_3$, 67 grams of CaO, 336 grams of $SrCO_3$, and 180 grams of CuO were mixed, melted, and quenched as in Example L. The resulting material was similar to Example L in appearance.

The chemical analysis of several of the above Examples are revealed in Table VI. These compositions have been normalized to the Bi or Bi-like structural component from the as analyzed Atomic Absorption and Inductively Coupled Plasma (ICP) data.

TABLE VI

| Example | Composition |
|---|---|
| I | $Bi_2Ca_{1.40}Sr_{1.45}Cu_{1.95}Al_{0.01}Si_{0.02}Fe_{0.01}Mg_{0.01}C_{0.05}O_{8.28}$ (showing "contaminants") |
| XXIV | $Bi_2Ca_{1.33}Sr_{0.99}Cu_{1.95}O_{7.71}$ |
| XXVI | $Bi_2Ca_{1.47}Sr_{0.97}Cu_{1.95}O_{7.84}$ |
| XXVIII | $Bi_2Ca_{1.07}Sr_{2.09}Cu_{2.34}(Al_{0.19})O_{9.33}$ |
| XXXII | $Bi_2Ca_{1.39}Sr_{2.55}Cu_{3.48}(Al_{0.26})O_{11.44}$ |
| XXXV | $Bi_2Ca_{4.94}Sr_{4.29}Cu_{5.99}O_{18.4}$ |
| XXXVI | $Bi_2Ca_{1.93}Sr_{1.97}Cu_{2.99}O_{10.42}$ |
| XXXVII | $Bi_2Ca_{1.66}Sr_{1.33}Cu_2O_{7.57}$ |
| XXXVIII | $Bi_2Ca_{1.35}Sr_{1.33}Cu_{2.67}O_{8.27}$ |
| XXXIX | $Bi_2Ca_{1.03}Sr_2Cu_{2.01}O_{8.33}$ |
| XL | $Bi_2Ca_{2.87}Sr_{4.12}Cu_{4.97}O_{16.45}$ |
| XLI | $Bi_{1.74}Pb_{.26}Ca_4Sr_{3.98}Ag_{.048}Cu_6O_{17.14}$ |
| XLII | $Bi_{1.83}Pb_{.17}Ca_{3.51}Sr_{4.30}Ag_{.15}Cu_{6.46}O_{17.27}$ |
| XLIII | $Bi_{1.56}Pb_{.44}Ca_{4.02}Sr_{3.95}Ag_{.023}Cu_{5.96}O_{17.49}$ |
| XLIV | $Bi_{1.7}Pb_{.3}Ca_{3.58}Sr_{3.59}Ag_{.37}Cu_{5.8}O_{16.08}$ |
| XLV | $Bi_{1.7}Pb_{.3}Ca_{3.91}Sr_{3.01}Ag_{.81}Cu_{5.77}O_{15.61}$ |
| XLVI | $Bi_{1.71}Pb_{.29}Ca_{2.93}Sr_{3.60}Li_{.4}Cu_{5.83}O_{16.25}$ |
| XLVII | $Bi_{1.71}Pb_{.29}Ca_{4.19}Sr_{3.69}Na_{.15}Cu_{5.87}O_{17.17}$ |
| XLVIII | $Bi_{1.71}Pb_{.29}Ca_{3.58}Sr_{3.14}K_{.31}Cu_{5.84}O_{16.62}$ |
| XLIX | $Bi_2Ca_{0.87}Sr_{1.46}Cu_{2.07}Al_{0.39}Zn_{0.54}O_{8.78}$ |

The analysis shows the presence of several impurities, such as aluminum oxide, carbon, silicon, iron, and magnesium. It is speculated that at the lower levels observed, except for aluminum, that these impurities have little effect on the superconductivity of the examples. It is unclear what effect aluminum has at the higher levels observed.

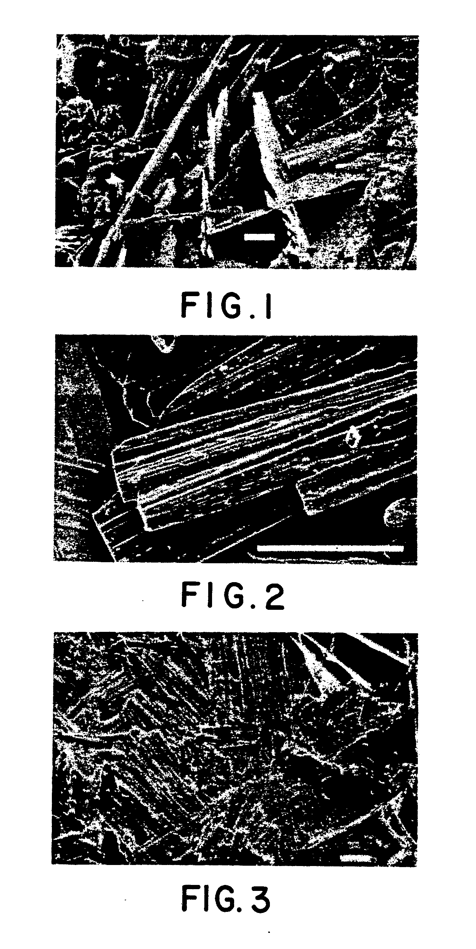

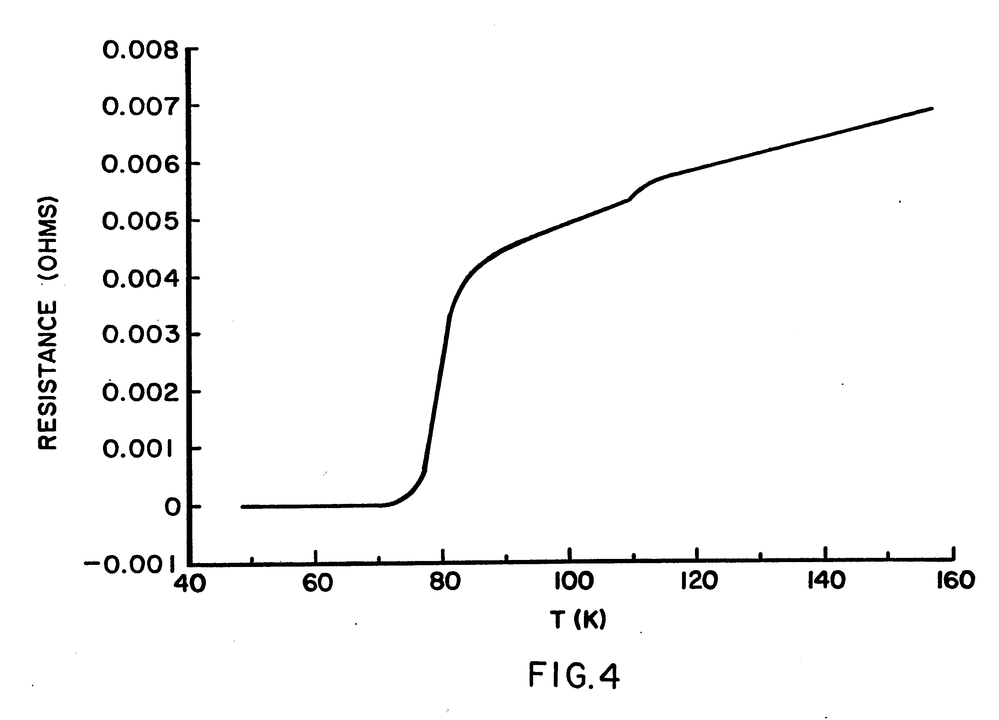

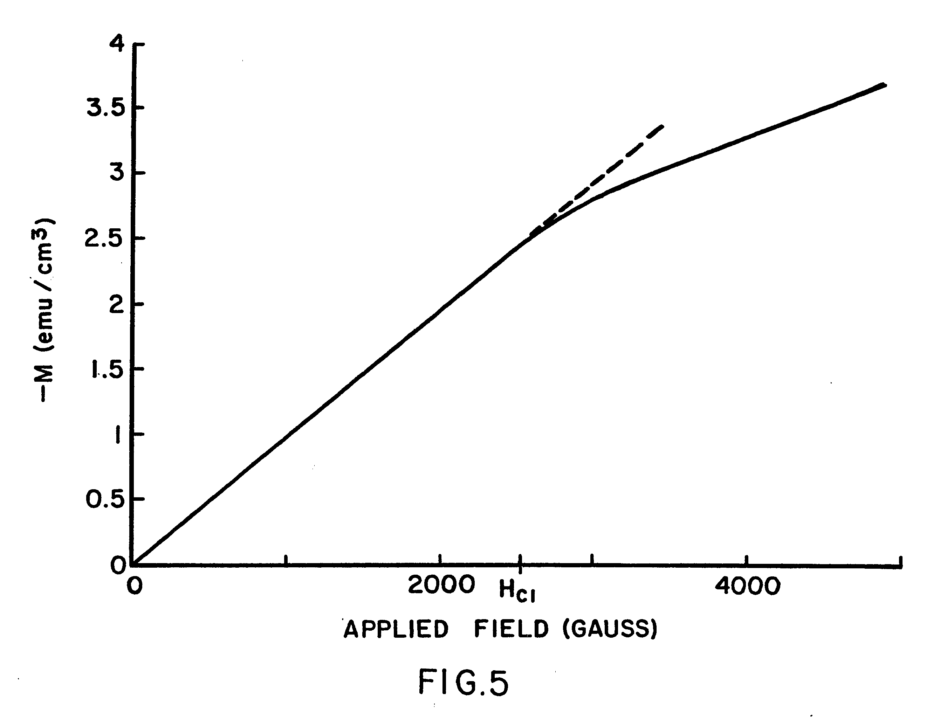

Fig. 1 shows the angularly juxtaposed platelets. The scale is 100 microns. Within this view, crystallites of up to 1000 microns are apparent. In expanded views crystallites of 1000 microns were noted. Generally, larger crystals indicate a higher aspect ratio. The grain sizes noted have been found to depend upon the heating temperature. The lower the temperature the smaller the grain size. Fig. 2 shows that the same platelets can be disposed parallel to one another with a consistent form. The scale is 100 microns. Fig. 3 shows an overall view of the composite superconducting material. Parallel or interwoven platelets may be important in the production of viable superconducting structures since the disposition of the platelets will provide a means for communicating, one from the other. It is noted that the platelets are interwoven. Interwoven platelets add vertical and lateral mechanical strength. The orientation of the platelets and/or crystallites may be effected by the orientation of the sample when heat treated. The aggregate crystal structure of 1 millimeter has been noted. By aggregate crystal structure is meant, a unified oriented crystallite or platelet aggregation. The scale is 100 microns. Fig. 4 shows a plot of resistance in ohms versus Temperature in Kelvins. The appearance of the discontinuity at approximately 115K is indicative of the presence of the $Bi_2(CaSr)_4Cu_3O_{10}$ type phase. At 85K the plot shows the onset temperature of bulk superconductivity. At 70K resistance is zero. Fig. 5 is a plot of the magnetization measurement. The dotted line shows where the measured magnetization deviates from linearity indicating the first critical field of greater than 2000 Gauss.

## Claims

1. A superconducting glass ceramic consisting essentially of the stoichiometric ratio $Bi_{2-m}Pb_mCa_xSr_z N_nCu_wO_y$, wherein N is selected from the group consisting of Li, K, Na, Zn, and Ag, m equals up to 1, x equals up to 10, z equals up to 10, n equals up to 2, w equals about to 7, and y equals up to 20.

2. A superconducting glass ceramic consisting essentially of the stoichiometric ratio $Bi_2Ca_xSr_zCu_wO_y$, wherein x equals up to 10, z equals up to 10, w equals about 2 to 7, and y equals up to 20.

3. A glass ceramic as claimed in claim 1 or claim 2 characterized in that the volume percent of superconductivity is up to 60% at 65K.

4. A glass ceramic as claimed in claim any of claims 1 to 3 characterized in that the first critical field is greater than 1000 Gauss.

5. A glass ceramic as claimed in claim any of claims 1 to 3 characterized in that the first critical field is greater than 2000 Gauss.

6. A Bi-Ca-Sr-Cu-O glass ceramic wherein platelets or crystallites are interwovenly, angularly and/or parallelly juxtapositionally disposed to each other.

7. A glass ceramic as claimed in any of claims 1 to 7 characterized in that species selected from the group consisting of silver, tin. lead, sodium, zinc, and potassium are substituted for either Ca, Sr, Cu, or Bi.

8. A glass ceramic as claimed in any of claims 1 to 7 characterized in that the platelets and/or crystallites orientation is determined by the orientation of said glass ceramic during heating.

9. A glass ceramic as claimed in any of claims 1 to 8 characterized in that platelets or crystallites are up to 1 millimeter in size.

10. A process for manufacturing a glass ceramic as claimed in any of claims 1 to 9 characterized in:
providing a batch material or bismuth, calcium, strontium, and copper,
melting said batch material to form a liquid,
quenching said liquid rapidly to form a glass,
heating said quenched glass to form a glass ceramic superconductor with platelets diagonally, parallelly, and/or interwovenly juxtapositionally disposed.

11. A process as claimed in claim 10 characterized in that the heating ranges from $650^\circ$C to $910^\circ$C, preferably $800^\circ$C to $890^\circ$C.

12. A process as claimed in claim 10 or 11 characterized in that the heating atmosphere is oxygen or air.

13. A process as claimed in any of claims 10 to 12 characterized in that the melting is performed at temperatures in the range from $1000^\circ$C to $1350^\circ$C.

FIG.1

FIG.2

FIG.3

FIG.4

FIG.5

EP 0 375 134 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | THE JAPANESE JOURNAL OF APPLIED PHYSICS (part 2: letters), vol. 27, no. 12, 20th December 1988, pages L2293-L2295; T. KOMATSU et al.: "Preparation of high Tc superconducting Bi-Pb-Sr-Ca-Cu-O ceramics by the melt quenching method" * The whole document * | 1-7,9-13 | C 03 C 10/02<br>C 04 B 35/00<br>H 01 L 39/12 |
| X | THE JAPANESE JOURNAL OF APPLIED PHYSICS (Part 2: letters), vol. 27, no. 9, September 1988, pages L1696-L1698; Y. AKAMATSU et al.: "Instantaneous preparation of superconducting thick films through melts in the Bi-Ca-Sr-Cu-O system" * The whole document * | 1-6,8-13 | |
| Y | IDEM | 7 | |
| X | PHYSICAL REVIEW B, vol. 38, no. 10, 1st October 1988, pages 7166-7168; H. ZHENG et al.: "Bi4Sr3Ca3Cu4O16 glass and superconducting glass ceramics" * The whole document * | 1-6,8-12 | TECHNICAL FIELDS SEARCHED (Int. Cl.5) |
| Y | IDEM | 7 | C 03 C<br>C 04 B<br>H 01 L |
| X | APPLIED PHYSICS LETTER, vol. 53, no. 5, 1st August 1988, pages 423-425; D.G. HINKS et al.: "Preparation of Bi-Sr-Ca-Cu-O superconductors from oxide-glass precursors" * The whole document * | 1-6,9-13 | |
| Y | IDEM                                          -/- | 7 | |

The present search report has been drawn up for all claims

| Place of search | Date of completion of the search | Examiner |
|---|---|---|
| THE HAGUE | 21-03-1990 | VAN BOMMEL L. |

EPO FORM 1503 03.82 (P0401)

European Patent
Office

EUROPEAN SEARCH REPORT

Application Number

EP  89 31 1547

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PHYSICA C/SUPERCONDUCTIVITY, vol. 156, no. 5, 1st December 1988, pages 822-826; D. SHI et al.: "110 K superconductivity in crystallized Bi-Sr-Ca-Cu-O glasses"<br>* Pages 822-824 * | 1-6,9-12 | |
| Y | IDEM<br>--- | 7 | |
| D,X | JAPANESE JOURNAL OF APPLIED PHYSICS (Part 2: letters), vol. 27, no. 4, April 1988, pages L550-L552; T. KOMATSU et al.: "High-Tc superconducting glass ceramics based on the Bi-Ca-Sr-Cu-O system"<br>* The whole document *<br>--- | 1-6,9-13 | |
| Y | ---<br> | 7 | |
| Y | JAPANESE JOURNAL OF APPLIED PHYSICS (Part 2: letters), vol. 27, no. 4, April 1988, pages L545-L547; T. HONDA et al.: "Preparation of high-Tc (105 K) superconducting phase in Bi-Sr-Ca-K-Cu oxide system"<br>* The whole document *<br>--- | 7 | TECHNICAL FIELDS SEARCHED (Int. Cl.5) |
| P,X | PHYSICA C, vol. 159, no. 3, 15th June 1989, pages 273-276; A.P. GONCALVES et al.: "Bi-Ca-Sr-Cu-O superconductors obtained by glass crystallisation; effect of potassium doping"<br>* Pages 274-276 *<br>----- | 1-13 | |

The present search report has been drawn up for all claims

| Place of search | Date of completion of the search | Examiner |
|---|---|---|
| THE HAGUE | 21-03-1990 | VAN BOMMEL L. |